Europäisches Patentamt

European Patent Office

Office européen des brevets

(11) Publication number:

**0 365 114**
**A2**

# (12) EUROPEAN PATENT APPLICATION

(21) Application number: **89307111.8**

(22) Date of filing: **13.07.89**

(51) Int. Cl.⁵: **G11C 29/00 , G06F 11/26**

(30) Priority: **18.10.88 GB 8824374**

(43) Date of publication of application:
**25.04.90 Bulletin 90/17**

(84) Designated Contracting States:
**DE FR GB**

(71) Applicant: **Hewlett-Packard Limited**
**Nine Mile Ride**
**Wokingham Berkshire RG11 3LL(GB)**

(72) Inventor: **Lloyd-Jones, Kevin**
**26 Foxfield Avenue**
**Bradley Stoke Bristol BS12 0BW(GB)**
Inventor: **McCarthy, Dominic Paul**
**5 Church Road**
**Stoke Gifford Bristol BS12 6QA(GB)**

(74) Representative: **Squibbs, Robert Francis et al**
**Hewlett-Packard Limited Nine Mile Ride**
**Wokingham Berkshire RG11 3LL(GB)**

(54) Interface arrangement for interfacing a data storage device with a data handling system.

(57) An interface arrangement is provided for interfacing, for example, a host computer with a tape drive. The interface arrangement includes a buffer memory (20), a first input/output channel (10,17) connecting the host computer to the buffer memory (20), and a second input/output channel (13,18) connecting the tape drive to the buffer memory (20). Test circuitry (40) is provided as part of the interface arrangement. The test circuitry (40) is operable to generate a test pattern to be down-loaded to the tape drive and then read back and compared with the original pattern to verify the operation of the tape drive. Preferably, the test circuitry (40) writes and reads the test patterns to and from the buffer memory (20) so that the transfer of the test patterns between the interface arrangement and the tape drive can be effected using the same procedures as for normal data transfers. The test circuitry (40) can also be used to check the buffer memory (20).

FIG 1

# INTERFACE ARRANGEMENT FOR INTERFACING A DATA STORAGE DEVICE WITH A DATA HANDLING SYSTEM

The present invention relates to an interface arrangement for interfacing a data storage device with a data handling system. More particularly, the present invention relates to the provision of test circuitry in such interface arrangements.

Interface arrangements are known of the type that comprise

- first input/output means for exchanging data and control signals with a data handling system,
- second input/output means for exchanging data and control signals with a data storage device,
- a buffer memory provided with a plurality of addressable storage locations, an address port, and a data port connected to both said input/output means, and
- control means connected to said first and second input/output means and to said address port of the buffer memory, the control means being operate to control the transfer of data in both directions between said first and second input/output means via said buffer memory.

Typically, the data handling system will be a host computer while the data storage device will be a tape or disc drive housed in the same unit as the interface arrangement. The first input/output means will generally provide for communication with the host computer using an industry standard protocol such as the SCSI (Small Computer Systems Interface) protocol, while the second input/output will often be an internal interconnection between the buffer memory and storage device that is closely integrated into the overall architecture of the combined interface arrangement and storage device. The general purpose of such interface arrangements is to match the differing requirements of the host computer and storage device particularly as regards data format and data rates.

In certain circumstances, the host will wish to carry out tests of the storage device by storing and reading back known data. This type of operation consumes a significant amount of processing power particularly where the storage device is a streaming tape drive. Indeed, it may well not be possible to carry out such tests on more than a single storage device at a time.

It is an object of the present invention to facilitate th testing of data storage devices.

According to one aspect of the present invention there is provided an interface arrangement of the aforesaid type, characterised in that the interface arrangement further comprises test circuitry including a pattern generator and a comparator, said control means being connected to control said test circuitry and being arranged to effect a data-compare test on said storage device by causing a test pattern generated by said pa tern generator to be passed to said storage device via said second input/output means and then read back from the storage device and compared with the generated pattern by said comparator.

Preferably, during said data-compare test on the storage device, the test pattern is first written into said buffer memory before being read out and passed via said second means to the storage device, while on reading back of the test pattern from the storage device, the read-back pattern is first written into said buffer memory before being fed to said comparator for comparison with the original pattern. By writing the test pattern into the buffer memory, no special measures are needed to transfer the test pattern to the storage device since the procedures for exchanging data between the buffer memory and storage device are already implemented.

Advantageously, the data-compare test is carried out in response to a predetermined control signal received by said control means via said first input/output means. Furthermore, the control means is preferably arranged to store the results of the said data-compare test and to output the results via the first input/output means upon receipt of a pre-specified control signal received via the input/output means.

The test circuity can with advantage also be used to carry out the normal power-on diagnostic test of the buffer memory by directly reading back a test pattern written to memory. In known systems in which the control means is generally implemented as a microprocessor, such a memory-bit test may take a significant amount of time; this can be unacceptable where the host/device protocol used (such as the SCSI protocol) expects connected devices to be very quickly available after power up. The present interface arrangement permits much quicker memory-bit tests to be performed as the test circuitry is dedicated to the task of pattern generation and comparison unlike the prior-art microprocessor based arrangements.

According to another aspect of the present invention, there is provided an interface arrangement of the aforesaid type which further comprises dedicated test circuitry including a pattern generator and a comparator, said control means being connected to control said test circuitry and being arranged to effect a memory-bit test on said buffer memory by causing a test pattern generated by said pattern generator to be written to the storage locations of the memory and then read back directly from the memory and compared with the original pattern in said comparator.

An interface arrangement embodying the invention will now be particularly described, by way of non-limiting example, with reference to the accompanying drawings in which;

Figure 1 is a block diagram of the interface arrangement;

Figure 2 is a block diagram showing the main components of a DMA controller of a buffer-memory sub-system shown in Figure 1;

Figure 3 is a diagram illustrating the service cycle operated by the DMA controller of Figure 2; and

Figure 4 is a block diagram of the Figure 1 buffer-memory sub-system showing the details of test circuitry incorporated in the sub-system.

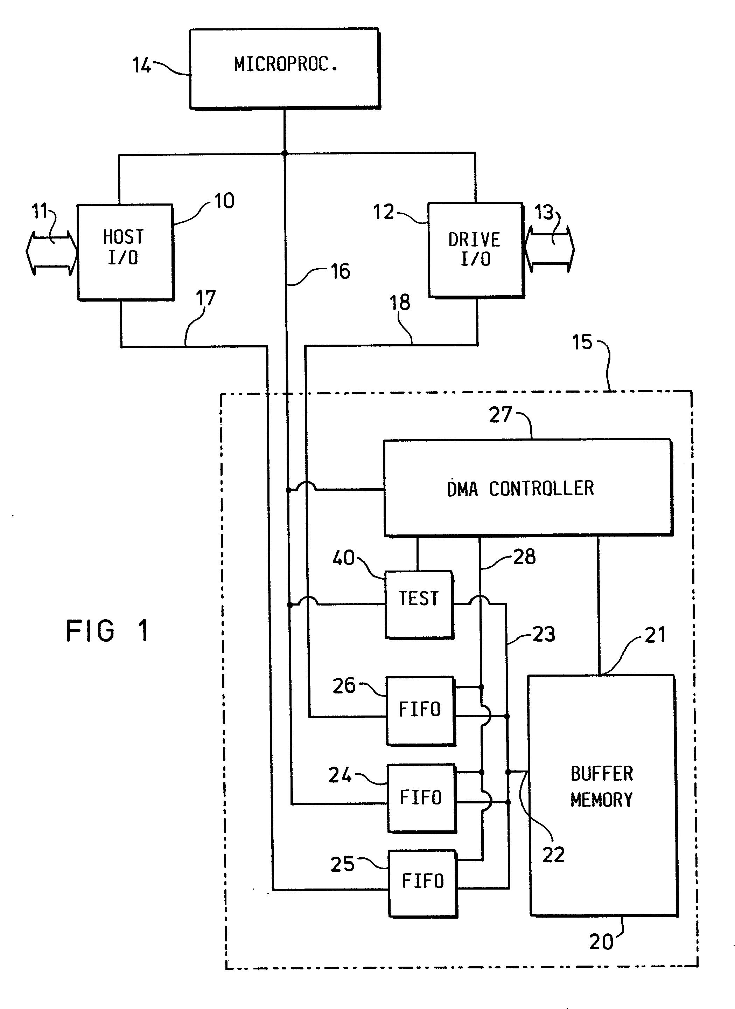

The interface arrangement shown in Figure 1 is intended to interface a data handling system (in the present case, a host computer) with a data storage device (in the present case, a tape drive). The host computer (not shown) is connected to an input/output circuit 10 of the interface arrangement by a bus system 11. The tape drive (not shown) is connected to an input/output circuit 12 of the interface arrangement by a bus system 13. Typically, the interface arrangement will be integrated with the tape drive itself so that the bus system 13 is an internal one; in contrast, the bus system 11 is external and communications over this system will generally take place in accordance with a standard protocol such as the SCSI protocol with the protocol interactions over the bus system 11 being handled by the input/output circuit 10.

In addition to the input/output circuits 10 and 12, the interface arrangement comprises a microprocessor subsystem 14 and a buffer memory subsystem 15. The microprocessor subsystem 14 comprises a microprocessor, ROM memory storing a control program, and a RAM memory. The function of the microprocessor subsystem 14 is to control the overall operation of the interface arrangement, this control being exerted via the microprocessor bus system 16 that extends between the microprocessor subsystem and the input/output circuit 10, 12 and the buffer memory subsystem 15. The input/output circuits 10 and 12 are connected to the buffer memory subsytem 15 by bus systems 17 and 18 respectively.

During data storage, the microprocessor subsystem 14 controls the input of data into the buffer memory subsystem 15 from the host computer via the bus system 11 and the input/output circuit 10 and the bus system 17, and the subsequent transfer of data from the buffer memory to the tape drive via the bus system 18, the input/output circuit 12 and the bus system 13. The buffer memory subsystem 15 permits the differing data rates and formats of the host system and tape drive to be matched to one another. The microprocessor subsystem 14 may also perform a reformatting function between the reading in of data into the buffer memory subsystem 15 and the reading out of data to the tape drive. In implementing this function, the microprocessor subsystem 14 is arranged to read data from the subsystem 15, and write it back to the buffer memory subsystem in a different arrangement possibly with the addition of format control codes.

During data read back, the microprocessor subsystem 14 oversees the reading in of data from the tape drive into the buffer memory subsystem 15 via the bus system 13, the input/output circuit 12 and the bus system 18, and the subsequent reading out of that data from the buffer memory subsystem 15 to the host computer via the bus system 17, the input/output circuit 10 and the bus system 11. In addition, the microprocessor subsystem 14 may effect a reverse formatting of the data held in the buffer memory subsystem 15 to that which was implemented during data storage.

In addition to the passage of data through the interface arrangement as described above, the microprocessor subsystem 14 will exchange control signals with the host computer and the tape drive via the corresponding input/output circuit and bus systems.

Interface arrangements operating in the above described manner are well known in the art and a more detailed description of the operation of the illustrated arrangement will not therefore be given herein.

The buffer memory subsystem 15 shown in Figure 1 includes a block of buffer memory 20 constituted, for example, by a plurality of dynamic RAM chips (not shown individually). The buffer memory has an address port 21 and a data port 22, the latter being connected to a buffer-memory data bus 23. The data buses of the bus systems 16, 17 and 18 are connected to the buffer-memory data bus 23 via respective FIFO (first-in, first-out stores) 24, 25 and 26.

The address port 21 of the buffer memory 20 is connected to a DMA (Direct Memory Access) controller 27 of the buffer-memory subsystem 15. The microprocessor bus 16 is connected to the DMA controller 17 to enable the microprocessor subsystem 14 to set up DMA transfers between the buffer memory 20 and the three data channels constituted by the bus systems 16, 17 and 18. The DMA controller 27 is arranged to select a particular data channel by means of control signals output via lines 28 to the FIFOS 24, 25 and 26, the latter being selectively connected to the buffer-memory data bus 23 under the control of these control signals.

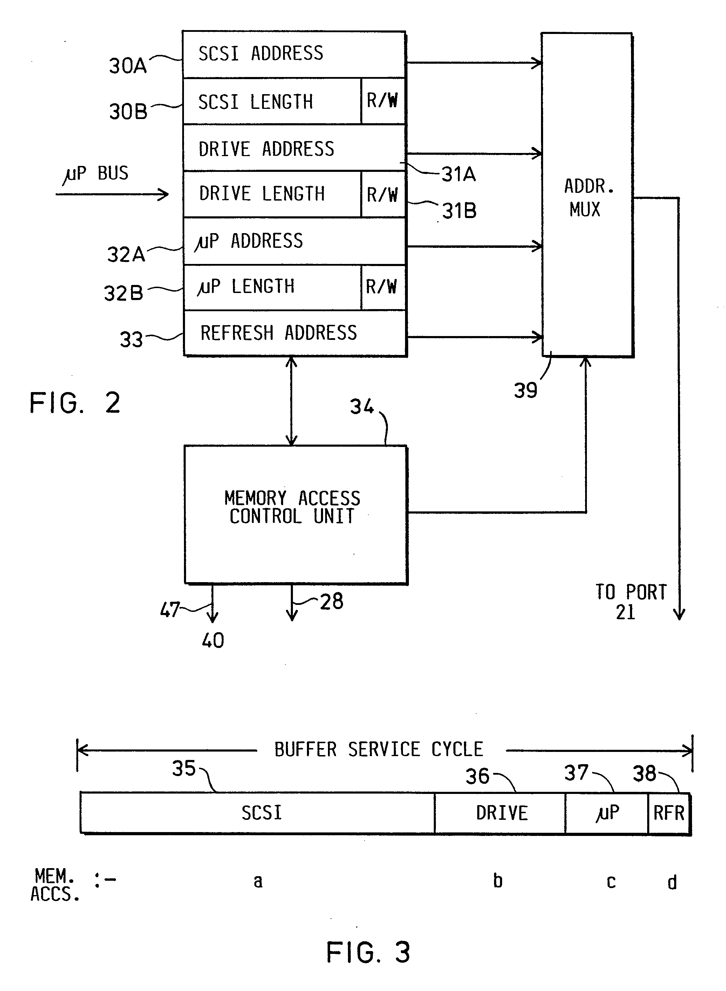

The DMA controller 27 is shown in more detail in Figure 2. In standard manner, the DMA controller includes a plurality of register pairs 30A, 30B; 31A, 31B; and 32A, 32B into which the microprocessor subsystem can write the parameters of required DMA transfers. The registers 30A and 30B contain the start address and block length of a required DMA transfer between the buffer-memory and the SCSI input/output circuit 10; the register 30B also contains a flag to indicate whether the transfer is a read from or a write to the buffer-memory. The registers 31A and 31B contain similar information in respect of transfers between the buffer-memory and the drive input/output circuit 12 while the registers 32A and 32B contain like information for transfers between the buffer memory and the microprocessor subsystem 14. A further register 33 contains the address of the storage locations next to be refreshed (the buffer-memory being constituted in the present example by dynamic RAMS).

The DMA controller 27 is provided with a memory access control unit 34. This control unit 34 operates on a cyclic basis to service the three data channels constituted by the bus systems 16, 17 and 18 and to permit refresh of the DRAMS making up the buffer memory. Figure 3 shows the makeup of a typical buffer-service cycle from which it can be seen that the data channel servicing the SCSI input/output circuit 10 is allocated "a" memory accesses, the data channel servicing the drive input/output circuit 12 is allocated "b" memory accesses, the data channel servicing the microprocessor subsystem 14 allocated "c" memory accesses, and "d" memory accesses are allocated to memory refresh. The division of the buffer service cycle between the data channels and refresh requirement is proportional (although not necessarily directly so) to the required data rates concerned. The values of "a", "b", "c" and "d" are settable by the microprocessor subsystem 14.

During the SCSI data channel phase of this service cycle, the control unit 34 connects the FIFO 25 to the buffer-memory data bus 23 and utilises the information contained in the registers 30A, 30B to produce appropriate addresses on the address port 21 of the buffer memory 20. This latter function is achieved by means of an address multiplexer 39 used to select the register 30A and by the control unit 34 advancing the access address after each memory access is effected. If during the phase 35 of the service cycle either no data transfer is required to/from the SCSI data channel or any required transfer is completed, the memory control unit 34 does not advance to the next service cycle phase but counts out the phase 35.

Upon completion of phase 35 of the service cycle, the control unit 34 disconnects the FIFO 25 from the data bus 23. Thereafter, phase 36 of the service cycle is entered in which the data channel constituted by the bus system 18 is serviced. This phase 36 progresses in a manner similar to that described above with reference to phase 35 except that now the FIFO 26 is connected to the data bus 23 and the information contained in the registers 31A, 31B is used to control the addresses supplied from the address multiplexer 39 to the address port 21 of the buffer-memory 20.

Similarly, during a phase 37 of the service cycle, the FIFO 24 is selectively connected to the data bus 23 and data is transferred between the buffer memory and microprocessor subsystem 14 in dependence on the information contained in the registers 32A, 32B.

During the fourth and final phase 38 of the service cycle, memory refresh circuitry (not shown but incorporated in the buffer memory 20) is enabled to refresh the storage locations (one column per access) of the DRAMS making up the buffer-memory. The storage locations refreshed are determined by the refresh column address contained in the register 33, this address being advanced as each column is refreshed.

The purpose of the FIFOS 24, 25 and 26 is to provide a temporary store for data transferred down the data channels to the buffer-memory during the phases of the service cycle when the corresponding channels are not being serviced. The capacity of each FIFO must therefore be sufficient to hold the maximum possible amount of data that could be received down the corresponding data channel during the phases of the service cycle that that channel is not being serviced. The sizes of the FIFOS will thus be dependent on the channel data rates and the ratios of the values a, b, c and d.

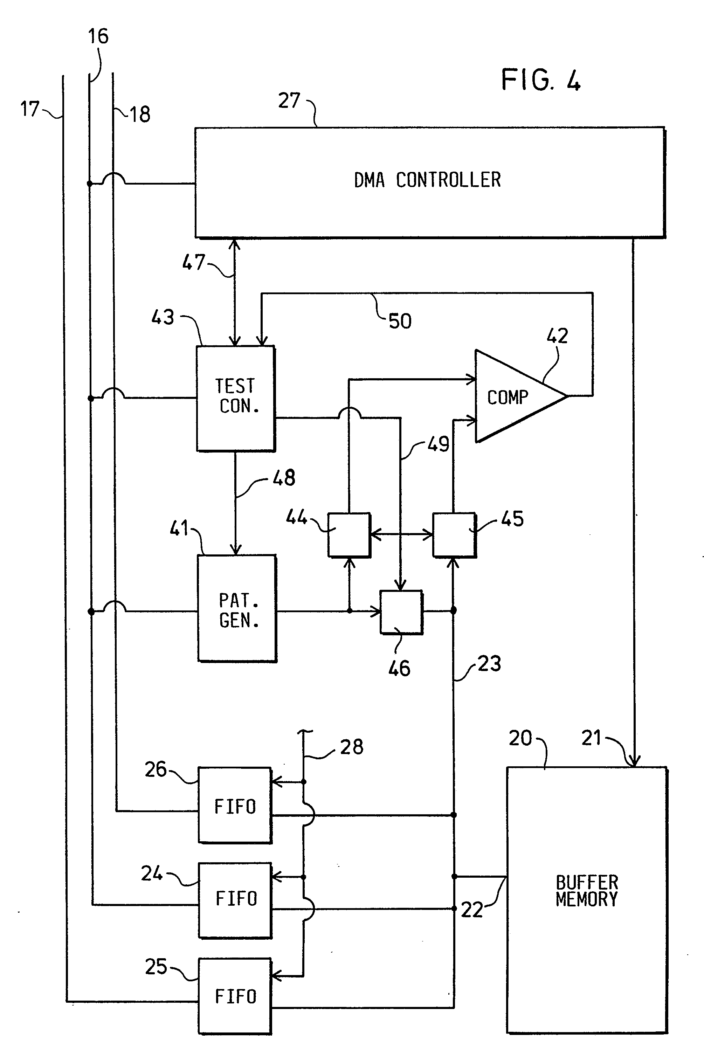

Referring again to Figure 1, the buffer-memory subsystem 15 further comprises test circuitry 40 connected to the microprocessor bus system 16, to the DMA controller 27 and to the buffer-memory data bus 23. As shown in Figure 4, this test circuitry comprises a pattern generator 41, a data comparator 42, a test controller 43 and data path gates 44, 45 and 46. Control lines 47, 48 and 49 connect the test controller 43 with the DMA controller 27, the pattern generator 41, and the gates 44-46. The output of the comparator 42 is connected back to the test controller via line 50.

The gate 46 when enabled by the test controller 43, permits the output of the pattern generator 41 to be put on the buffer-memory data bus 23. When the gate 46 is inhibited and the gates 44 and 45 enabled, the comparator 42 is fed both with the output of the pattern generator 41 and with the data present on the buffer-memory data bus 23.

The constituent elements 41 to 46 of the test circuitry 40 are dedicated hardware components rather than program sequencing components and so are able to operate at higher speeds than if implemented using a program controller microprocessor.

At the instigation of the microprocessor subsystem 14, the test controller 43 is arranged to carry out either of the one of the following two tests, as required by the microprocessor subsystem:

a) a memory bit test on the storage locations of the buffer memory 20;

b) a data-compare test on the storage device.

The memory bit test will generally be instigated by the microprocessor at power up. Upon being requested to run this test, the test controller 43 writes a test pattern output by the generator 42 to the buffer memory 20. For this purpose, the controller 43 enables the gate 46 and also passes a signal to the memory access control unit 34 of the DMA controller 27 to cause the latter to sequence through the address space of the buffer memory 20. Any suitable test pattern may be used for this purpose, a number of appropriate patterns being well known to persons skilled in the art. In fact, the microprocessor bus is connected to the pattern generator 41 to enable the latter to be seeded from the microprocessor subsystem 14 with an appropriate generator polynomial. After the test pattern has been written to the buffer memory 20, the test controller 43 causes the DMA controller 27 to read back the contents of the buffer memory on to the data bus 23. At the same, the controller 43 enables the gates 44 and 45 and causes the pattern generator 41 to regenerate the original test pattern. As a result, both the original test pattern and the stored and read back test pattern are fed to the comparator 42 for comparison with each other. The results of this comparison are fed back to the controller 43 via line 50. The controller 43 accumulates these results in an internal register. Upon request from the microprocessor subsystem 14, the test controller 43 passes back the memory bit test results to the subsystem 14 which then makes a decision as to whether the memory is operating satisfactorily.

The overall control of the data-compare test is effected by the microprocessor subsystem 14 and generally such a test will only be instigated by the host computer system passing a request via the bus system 11 and input/output circuit 10 to the microprocessor subsystem 14. During the first phase of the data compare test, the microprocessors subsystem 14 requests the test controller 43 to write a test pattern into the buffer memory 20; the controller 43 carries out this task in the same -manner as described above for the memory-bit test. Upon the test pattern being written into the buffer memory 20, this fact is indicated to the subsystem 14 by the controller 43. Thereafter, the microprocessor subsystem 14 controls the transfer of the contents of the buffer-memory 20 to the storage device via the bus system 18, the input/output circuit 12 and the bus system 13.

Next, the microprocessor subsystem 14 causes the test pattern data to be read back from the storage device into the buffer memory. Both during this process and in the preceding process of writing the data to the storage device, the normal cyclic operation of the DMA controller is suspended and the latter services the storage-device data channel to the exclusion of the other data channels (memory refresh is effected as normal).

After the test pattern data has been read back into the memory 20, the microprocessor subsystem 14 causes the test controller 43 to compare the contents of the memory with the original test pattern in the manner previously described with reference to the memory-bit test. Again, the results of the comparison are made available to the microprocessor subsystem.

The above described test circuit arrangement provides a number of advantages. More particularly, the dedicated nature of the circuitry ensures a much faster testing of the memory as compared to microprocessor-run tests. Furthermore, the use of the test circuitry to carry out data-compare tests on the storage device relieves the host computer of this task which, with all the overheads of the interfacing protocols, can place a significant strain on the resources of the host computer particularly where the storage device is a streaming tape drive. The dual use of the test circuitry also offers greater efficiency particularly where the interface arrangement as a whole is integrated into just a few chips.

## Claims

1. An interface arrangement for interfacing a data storage device with a data handling system, said interface arrangement comprising
- first input/output means for exchanging data and control signals with said data handling system,
- second input/output means for exchanging data and control signals with said storage device,
- a buffer memory provided with a plurality of addressable storage locations, an address port, and a data port connected to both said input/output means, and
- control means connected to said first and second input/means and to said address port of the buffer memory, said control means being operative to control the transfer of data in both directions between said first and second input/output means via said buffer memory. characterised in that the interface arrangement further comprises test circuitry including a pattern generator and a comparator, said control means being connected to control said test circuitry and being arranged to effect a data-compare test on said storage device by causing a test pattern generated by said pattern generator to be passed to said storage device via said second input/output means and then read back from the storage device and compared with the generated pattern by said comparator.

2. An interface arrangement according to claim 1, wherein during said data-compare test on the storage device:
- the test pattern is first written into said buffer memory before being read out and passed via said second means to the storage device; and
- on reading back of the test pattern from the storage device, the read-back pattern is first written into said buffer memory before being fed to said comparator for comparison with the original pattern.

3. An interface arrangement according to claim 1, wherein the data-compare test is carried out in response to a predetermined control signal received by said control means via first input/output means.

4. An interface arrangement according to claim 1, wherein said control means is operative to store the results of said data-compare test and to output said results via the first input/output means upon receipt of a predetermined control signal received via the first input/output means.

5. An interface arrangement according to any one of the preceding claims, wherein said control means is further arranged to effect a memory-bit test on said buffer memory by causing a test pattern generated by said pattern generator to be written to the storage locations of the memory and then read back from the memory and compared with the generated pattern by said comparator.

6. An interface arrangement for interfacing a data storage device with a data handling system, said interface arrangement comprising
- first input/output means for exchanging data and control signals with said data handling system,
- second input/output means for exchanging data and control signals with said data storage device,
- a buffer memory provided with a plurality of addressable storage locations, an address port, and a data port connected to both said input/output means, and
- microprocessor means connected to said first and second input/output means and to said address port of the buffer memory, said microprocessor means being operative to control the transfer of data in both directions between said first and second input/output means via said buffer memory, and said microprocessor means being further operative to control the carrying out of a memory-bit test on said buffer memory by causing a test pattern to be written to said storage locations of the buffer memory and then read back and compared with the original pattern,
characterised in that the interface arrangement further comprises dedicated test hardware circuitry for use in said memory-bit test, said test circuitry including a pattern generator for generating said test pattern and a comparator for comparing the pattern read back from the buffer memory with the original pattern.

EP 0 365 114 A2

FIG 1

FIG. 2

| 30A | SCSI ADDRESS | |
| 30B | SCSI LENGTH | R/W |
| | DRIVE ADDRESS | |
| | DRIVE LENGTH | R/W |
| 32A | µP ADDRESS | |
| 32B | µP LENGTH | R/W |
| 33 | REFRESH ADDRESS | |

µP BUS

ADDR. MUX

31A
31B

39

MEMORY ACCESS CONTROL UNIT    34

47    28
40

TO PORT 21

BUFFER SERVICE CYCLE

| 35 | SCSI | 36 DRIVE | 37 µP | 38 RFR |

MEM. ACCS. :—    a    b    c    d

FIG. 3

FIG. 4